# EUROPEAN PATENT SPECIFICATION

(11) **EP 1 928 090 B1**
(45) Date of publication and mention of the grant of the patent: **27.04.2011**
(21) Application number: 07254652.6
(22) Date of filing: 30.11.2007
(51) Int. Cl.: H03K 17/082

(54) **Solid state power controller with lightning protection**
Festkörperleistungsregler mit Blitzschutz
Contrôleur d'alimentation à l'état solide avec protection d'éclairage

(30) Priority: 30.11.2006 US 606795
(43) Date of publication of application: 04.06.2008
(60) Divisional application: 11156482.9
(73) Proprietor: Hamilton Sundstrand Corporation, Windsor Locks, CT 06096-1010 (US)
(72) Inventor: Kilroy, Donald G., Rockford, IL 61108 (US); Maier, Josef, 86754 Munningen (DE); Robertson, Nicholas J., Rockford, IL 61107 (US); Lofflad, Bernd, 86720 Nordingen-Lopsingen (DE)
(74) Representative: Tomlinson, Kerry John

(56) References cited:
- EP-A- 1 298 770
- US-A- 5 440 441
- US-A- 5 550 701
- US-A- 5 752 047
- US-A1- 2004 156 154
- US-A1- 2006 101 296
- US-B1- 6 525 918
- US-B1- 6 768 350
- HAMMERTON C: "TOPFET - A NEW CONCEPT IN PROTECTED MOSFET" ELECTRONIC COMPONENTS AND APPLICATIONS, PHILIPS, EINDHOVEN, NL, vol. 10, no. 4, 1 January 1992 (1992-01-01), pages 153-168, XP000304697 ISSN: 0141-6219

## Description

### BACKGROUND OF THE INVENTION

This invention relates to vehicle power systems and, more particularly, to solid state power controls.

Vehicles, such as aircraft, typically utilize one or more power distribution units to distribute power from a primary power source to various vehicle systems. The solid state power controls in a power distribution unit typically include an electronic switch, such as a FET, and electronic circuitry that provides wiring protection. The FET and circuitry are often referred to as a solid state power controller ("SSPC"). The SSPC has found widespread use because of its desirable status capability, reliability, and packaging density. A typical power distribution unit may include hundreds or thousands of SSPCs.

SSPCs also must operate in the presence of lightning, which can adversely impact electronic devices. Traditionally, aircraft had an aluminum skin that attenuated the lightning current induced on the wires. Some aircraft now use composite materials instead of aluminum for weight and strength benefits. However, composite materials do not provide the same level of attenuation to lightning as aluminum. When lightning occurs, hundreds of volts may surge between a load in the vehicle system and the aircraft chassis. As such, the lightning requirements of SSPCs have increased.

The increase in lightning levels poses a significant additional burden because the SSPC does not provide galvanic isolation in the off state, as would a typical electro-mechanical circuit for example. Instead, the SSPC uses the FET for switching and the electronic circuit to provide the circuit breaker function, If the SSPC is in an off state when lightning strikes, the large voltage potential will undesirably increase the voltage across the FET. This is the case, for example, with the power MOSFET disclosed in US 5,550,701, which is turned off in response to overcurrent conditions.

An over-voltage clamp can be used to protect the FET from exceeding its maximum voltage capability by placing the FET into a linear region. However, the increased power dissipation of the FET in the linear region limits the amount of lightning energy that can be dissipated. Alternatively, high voltage FETs may be used to block the voltage in the off state, transient suppression devices can be placed across the FETs or more parallel FETs may be added, but these solutions are expensive, require larger packaging, and reduce reliability. Additionally, to protect the loads, a transient voltage suppression is often used by the load to shunt or divert the lightning current. This further increases the lightning energy that the SSPC must survive.

Document EP 0 858 164 A2 discloses a solid state power controller comprising such an over-voltage clamp that operates in conjunction with a protection circuit having temperature sensing means in such a way that when excessive power dissipation takes place in the power switch whilst said power switch is controlled to be OFF, the power switch is fully turned on.

There is a need for a simple, relatively inexpensive SSPC with improved lightning protection. This invention addresses those needs while avoiding the shortcomings and drawbacks of the prior art.

### SUMMARY OF THE INVENTION

The present invention provides a solid state power controller as set forth in claim 1.

The invention enables the SSPC to survive a lightning threat and return a load to its defined state once the threat has passed. The method described is suitable for most single-stroke lightning applications and may be suitable for many multiple- , stroke lightning applications. However, additional enhancements can be made to prevent repeated potential cycling off and on under an auto-recover mechanism during a multiple-stroke lightning application. There is a need for a simple, relatively inexpensive SSPC with improved lightning protection, that is suitable for exposure to multiple-stroke lightning, that can operate within a lightning environment with minimal system disruption, and that can protect loads from multiple power cycling.

According further to the invention SSPC software communicates to a main microprocessor module that a lightning pulse has occurred. The microprocessor module collects and processes this information. If a sufficient number of lightning indications are collected, the microprocessor module notifies other associated SSPCs in the system to lockout an instantaneous trip protection. When their instantaneous trip lockout is engaged, the SSPCs will not trip on lightning current pulses even if the current exceeds an instantaneous trip threshold. This prevents nuisance trips and ensures that current will pass to a load or plurality of loads, leaving the SSPCs undamaged.

### BRIEF DESCRIPTION OF THE DRAWINGS

The various features and advantages of this invention will become apparent to those skilled in the art from the following detailed description of the currently preferred embodiment. The drawings that accompany the detailed description can be briefly described as follows.
Figure 1 illustrates selected portions of an example solid state power controller with lightning protection.
Figure 2 illustrates selected portions of another example solid state power controller with lightning protection.
Figure 3 illustrates a microprocessor module and a plurality of SSPCs that communicate through a serial hardware interface.
Figure 4 illustrates a plurality of power distribution units and an associated microprocessor module in an example environment of an aircraft.

### DETAILED DESCRIPTION OF THE PREFERRED EMBODIMENTS

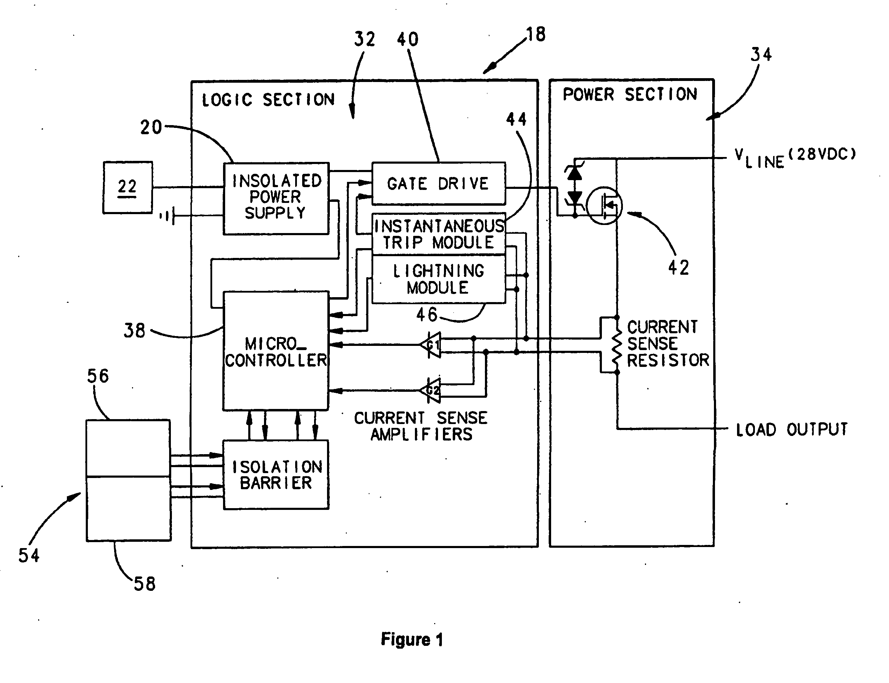

Figure 1 illustrates selected portions of an example solid state power controller (SSPC) 18 for use in a vehicle, such as an aircraft. Under some conditions, such as a lightning strike, a transient current may surge through the vehicle. The transient current may be, for example, an induced current, other known types of transient current, or a transient current from another source besides lightning. In the disclosed example, the SSPC 18 provides lightning protection to reduce the risk that the SSPC 18 becomes damaged from the transient current. As will be appreciated from the illustration and the following description, the SSPC 18 of the disclosed examples provides lightning protection without significant packaging density, reliability, or cost penalty. Although the SSPC 18 is a direct current type in the disclosed examples, one of ordinary skill in the art who has the benefit of this disclosure will recognize that the disclosed examples are also applicable to alternating current type SSPCs.

In this example, the SSPC 18 includes a logic section 32 and a power section 34. The logic section 32 includes a power supply 20, which provides power to a microcontroller 38 that controls operation of the SSPC 18. Power supply 20 is connected both to ground and to a power source 22. The microcontroller 38 interfaces with a gate drive 40, a switch 42, an instantaneous trip module 44, and a lightning module 46. Although only one switch 42 is shown in this example, multiple switches 42 may be used in the same manner as described. The instantaneous trip module 44 and lightning module 46 sense the electrical current flow through the SSPC 18.

In the disclosed example, the microcontroller 38 is in serial communication with a vehicle control 54. In this example, the vehicle control 54 includes an active microprocessor 56 and a standby microprocessor 58. The active microprocessor 56 communicates with the microcontroller 38 to control the operation of the SSPC 18. The standby microprocessor 58 communicates with the microcontroller 38 to establish or maintain a status of the SSPC 18. Each of the active microprocessor 56 and the standby microprocessor 58 send periodic signals to the microcontroller 38 to confirm that communication between the vehicle control 54 and the SSPC 18 has not been interrupted.

The instantaneous trip module 44 includes associated instantaneous trip logic and the lightning module 46 includes an associated lightning logic. The SSPC 18 responds in a variety of ways to a transient current, depending on the magnitude of the current flowing through the SSPC 18, a preset instantaneous trip threshold associated with the instantaneous trip module 44, a preset lightning threshold associated with the lightning module 46, and whether the SSPC 18 is an ON state (e.g., switch 42 is closed/ON) or an OFF state (e.g., switch 42 is open/OFF).

Currents larger than the instantaneous trip threshold are possible with loads that have transient voltage suppression (e.g., shunts) or loads that are highly capacitive in nature. In the disclosed example, the switch 42 includes a voltage clamp circuitry that protects the switch 42 in a known manner from certain voltage transients. The voltage clamp activates in a linear region to dissipate energy to thereby absorb transient currents up to the instantaneous trip threshold. Beyond the instantaneous trip threshold, the instantaneous trip module 44, the lightning module 46, and their associated logic protect the SSPC 18 from the transient current, as will be described below.

The following examples illustrate the operation of the instantaneous trip module 44 and the lightning module 46 under various conditions for transient currents. In the disclosed examples, turning ON the SSPC 18 passes the transient current to the load and thereby protects against formation of a fusible link and destruction of the switch 42. The below examples are intended only to illustrate concepts of the instantaneous trip module 44 and the lightning module 46, and one of ordinary skill who is given this description will recognize application of the concepts to other examples.

In one example, the SSPC 18 is OFF when the transient current occurs. Under this condition (i.e., SSPC 18 OFF), the only time that the current is expected to increase above the instantaneous trip threshold is if the SSPC 18 line Vₗᵢₙₑ or load output connection is shorted to a source voltage that exceeds the switch 42 over-voltage clamp protection, or if the SSPC 18 line Vₗᵢₙₑ or load connection is coupled to a transient voltage that exceeds the switch 42 over-voltage clamp protection. The switch 42 over-voltage clamp protects the switch 42 by turning on in a linear region to dissipate energy in a known manner. This provides the benefit of absorbing transient currents up to the instantaneous trip threshold. If, however, the transient current exceeds the instantaneous trip threshold, the instantaneous trip module, the lightning trip module and their associated logic function to protect the switch 42.

In the disclosed example, if the transient current increases above the instantaneous trip threshold, the instantaneous trip module 44 turns on the gate drive 40 to turn ON the switch 42. In this example, the switch 42 can handle more transient current when ON because the voltage across the switch 42 will be lower, which reduces the transient energy that switch 42 must absorb. The transient current flows to the load during this time to thereby protect the SSPC 18 from damage. As the transient current decreases below the instantaneous trip threshold, the instantaneous trip module 44 removes the gate drive 40 command to force the switch 42 OFF. Optionally, a time delay is used before turning off gate drive 40 to allow the SSPC 18 to cool.

The direct communication between the instantaneous trip module 44 and the gate drive 40 provides the benefit of allowing transient current protection even when the microcontroller 38 is in an inactive mode (e.g., a sleep mode). In a sleep mode for example, the microcontroller 38 software will not be awake to control the SSPC 18 to respond to a lightning threat. By directly linking the instantaneous trip module 44 and the gate drive 40, the instantaneous trip module 44 can directly control the gate drive 40 without the microcontroller 38 to quickly turn ON the switch 42.

In another example, the SSPC 18 is ON when the transient current occurs. The transient current increases the current through the switch 42 until the instantaneous trip threshold is exceeded. At this point, the microcontroller 38 begins to turn OFF the switch 42 and set an auto-recover function. The process of turning OFF the switch 42 takes some time, typically fractions of a second. During this time, the current may increase, decrease, or remain steady.

If the current increases, but not fast enough to exceed the lightning threshold before the switch turns OFF, the switch 42 is turned back ON upon exceeding the lightning threshold. If the current increases quickly enough to exceed the lightning threshold before the switch 42 turns OFF, the microcontroller 38 cancels the command to turn OFF the switch 42 such that the switch remains ON. In the ON state, the transient current passes to the load to thereby protect the SSPC 18 from damage.

If the transient current decreases or remains steady and does not reach the lightning threshold, the switch 42 turns OFF and the auto-recover logic functions to turn the SSPC 18 back ON after a time delay time to allow cooling.

After the switch 42 is turned back ON, if the current remains above the instantaneous trip threshold but below the lightning threshold, the switch 42 turns OFF and the auto-recover logic again functions to turn the SSPC 18 back ON after another time delay time to allow cooling. It is assumed that current above the instantaneous trip threshold is from a shorted load and not lightning if multiple attempts to auto-recover continue to produce current above the instantaneous trip threshold but below the lightning threshold. In response, a protective trip is set in the microcontroller 38, and the SSPC 18 turns OFF.

The auto-recover logic can also be used in SSPCs that do not include the lightning module 46. In such an embodiment, the instantaneous trip module 44 and its associated instantaneous trip threshold function to turn the SSPC 18 OFF if the current through the switch 42 exceeds the instantaneous trip threshold. The auto-recover logic turns the switch 42 back ON after a time delay time to allow cooling. If the current remains above the instantaneous trip threshold, the switch 42 turns OFF. The auto-recover logic again functions to turn the SSPC 18 back ON after another time delay time to allow cooling. If multiple attempts to auto-recover continue to produce current above the instantaneous trip threshold, a protective trip is set in the microcontroller 38, and the SSPC 18 turns OFF. The auto-recover logic provides the benefit of automatically resetting the switch 42 without the need for manual resetting (e.g., from an aircraft pilot), which is a drawback of prior SSPCs.

Thus, the disclosed examples provide for turning the SSPC 18 ON in response to the transient current exceeding the instantaneous trip threshold or lightning threshold, depending on the initial ON or OFF state of the SSPC 18. This provides the benefit of passing the transient current on to the load to protect the SSPC 18 from damage. Furthermore, the lightning module 46 requires little additional hardware in the SSPC 18, which helps keep costs and packaging density low.

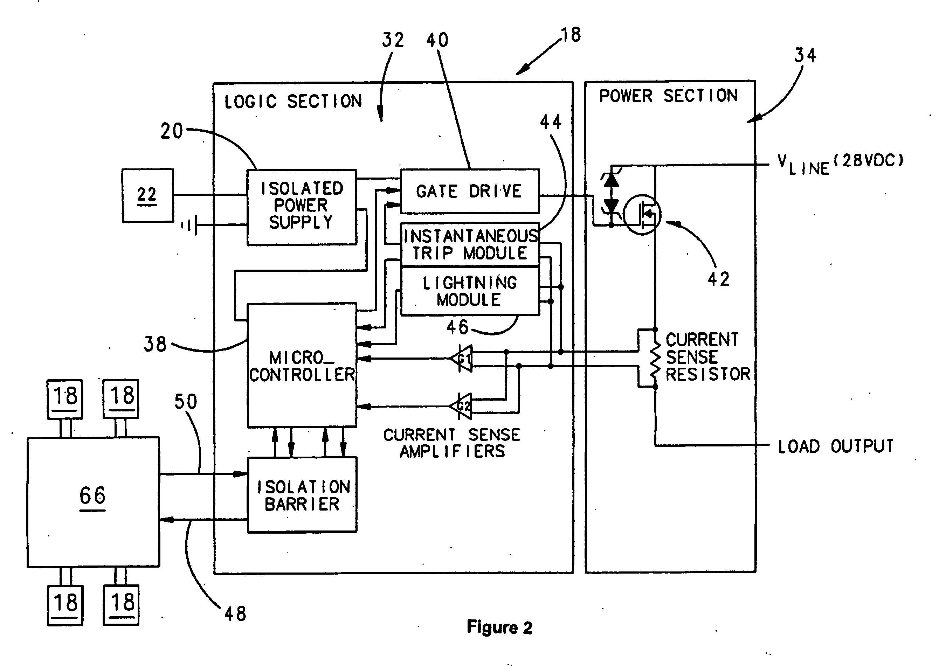

Figure 2 illustrates selected portions of another example solid state power controller (SSPC) 18 for use in a vehicle, such as an aircraft. For the purposes of this discussion a single FET is shown, while in practice it is common to have multiple FETs in parallel. In this example, the SSPC 18 also includes a logic section 32 and a power section 34. The logic section 32 includes an isolated power supply 20, which channels power from a power source 22 to a microcontroller 38 and a gate drive 40. The microcontroller 38 controls gate drive 40, which opens and closes a switch 42. When the gate drive 40 is turned on, the switch 42 is closed and the SSPC 18 turns ON. When the gate drive 40 is turned off, the switch 42 is opened and the SSPC 18 turns OFF. Although only one switch 42 is shown in this example, multiple switches may be used in the same manner as described. An instantaneous trip module 44 and a lightning module 46 sense the electrical current flow through the SSPC 18. Instantaneous trip module 44 acts as a comparator, and determines when current meets or exceeds an instantaneous trip threshold. Lightning module 46 also acts as a comparator, and determines when current meets or exceeds a higher lightning threshold. Microcontroller 38 transmits data to an SSPC communications interface 66 via communications line 48. The SSPC communications interface 66 transmits data back to the microcontroller 38 via communications line 50. The SSPC communications interface 66 also communicates with other SSPCs 18.

Under some conditions, such as a lightning strike, a transient current may surge through the vehicle. The transient current may be, for example, an induced current, other known type of transient current, or a transient current from another source besides lightning. In the disclosed example, the SSPC 18 provides lightning protection to reduce the risk that the SSPC 18 becomes damaged from the transient current.

The operation of the SSPC 18 is as described above. Thus, the disclosed examples provide for turning the SSPC 18 ON in response to the transient current meeting or exceeding the instantaneous trip threshold or lightning threshold, depending on the initial ON or OFF state of the SSPC 18. This provides the benefit of passing the transient current on to the load to protect the SSPC 18 from damage. Furthermore, the lightning module 46 requires little additional hardware in the SSPC 18, which helps keep costs and packaging density low. Although the SSPC 18 as shown in Figure 2 is a direct current type, one of ordinary skill in the art who has the benefit of that disclosure will recognize that the disclosed examples are also applicable to alternating current type SSPCs.

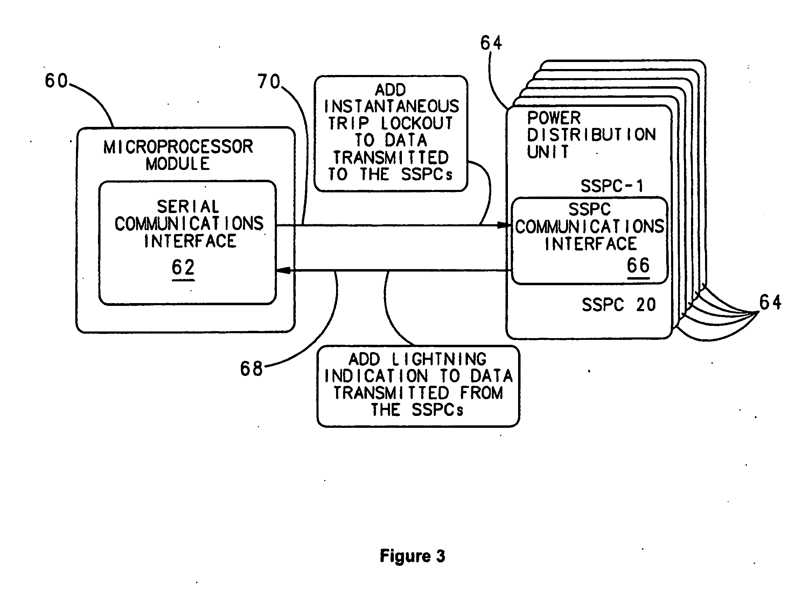

Figure 3 illustrates how a microprocessor module 60 communicates with a plurality of power distribution units 64, which each contain a plurality of SSPCs. The microprocessor module 60 has a serial communications interface 62, and each of the plurality of power distribution units 64 has an SSPC communications interface 66. The power distribution units 64 transmit serial data over communication line 68 to the microprocessor module 60. The microprocessor module 60 transmits serial data over communication line 70 to the plurality of power distribution units 64. All of the serial data is communicated between the interfaces 62 and 66.

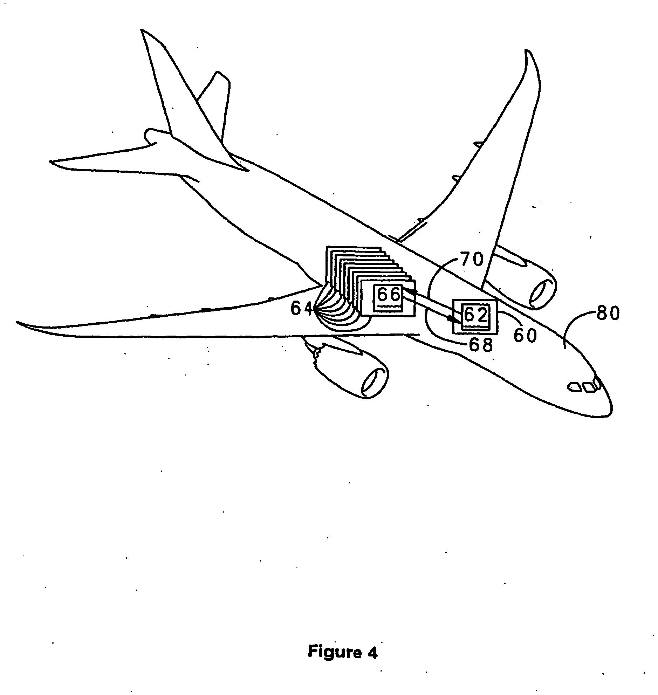

Figure 4 illustrates a microprocessor module 60 and a plurality of power distribution units 64 in an example environment of an aircraft 80. Serial data is transmitted between the microprocessor module 60 and the plurality of power distribution units 64 via communications interfaces 62 and 66 and serial data communication lines 68 and 70.

If certain conditions are met, the SSPC software will notify the microprocessor module 60 that a lightning pulse has occurred. In one example, there are two conditions the microcontroller 38 will use to determine if lightning has occurred: in a first case if current meets or exceeds an instantaneous trip threshold, and in a second case if current exceeds the instantaneous trip threshold and meets or exceeds a lightning threshold.

In the first case, the current in an SSPC meets or exceeds the instantaneous trip threshold. The microcontroller 38 of the SSPC would then add lightning indication to the data transmitted to the microprocessor module 60 along communication line 68. This case accommodates AC SSPCs that do not have a lightning module.

In the second case, when the instantaneous trip threshold has been reached, transient current meets or exceeds the higher lightning threshold of an SSPC. The microcontroller 38 of the SSPC would then add a lightning indication to the data transmitted to the microprocessor module 60 along communication line 68. This case, however, only applies to DC SSPCs, as AC SSPCs do not contain a lightning module to measure the lightning threshold.

When a sufficient number of conditions have been reached within one of the plurality of power distribution units 64, the microprocessor module 60 will command all SSPCs within the power distribution unit that have been commanded ON to lockout their instantaneous trip protection until a predetermined period, e.g. 1.5 seconds, has transpired. The instantaneous trip lockout command is transmitted along with other data to the power distribution unit 64 along communication line 70. An example sufficient number of conditions is greater than two, which accommodates the possibility that up to two SSPCs may exceed their instantaneous trip threshold due to a pin-to-pin short circuit, and not due to lightning. The ARP5412A industry standard defines lightning as extending up to 1.5 seconds and including up to 14 pulses randomly spaced between 10 and 200 milliseconds. To accommodate this industry standard, other SSPC functions, such as arc fault protection, can also be inhibited for 1.5 seconds if desired. It would be obvious to one skilled in the art to alter the present invention to meet different industry standards of greater than or less than the 1.5 second lightning duration, or to alter the instantaneous trip 1.5 second lockout time accordingly for this, or other reasons.

An SSPC whose instantaneous trip protection is locked out will allow current to pass from the SSPC to the load, even if that current meets or exceeds the instantaneous trip threshold. By preventing the instantaneous trip and allowing the current to pass to the load, the SSPC is left undamaged. In addition, these locked out SSPCs will not have to repeatedly turn off and back on to check if the lightning threat is still present. By locking out the instantaneous trip protection for the entire 1.5 second duration of the lightning threat, nuisance trips and power cycling are avoided. SSPCs will still follow normal control ON/OFF commands as described above during this time. In addition, SSPCs will also maintain wiring protection via the normal SSPC overcurrent trip curve protection during this time. The SSPC overcurrent trip curve protection enables the SSPC to set a circuit breaker protective trip in response to a sufficiently high current.

When the 1.5 second timer of the microprocessor module 60 expires, the instantaneous trip lockout will be reset. Once the lockout is removed, the SSPCs restore their instantaneous trip protection.

The microprocessor module 60 can use other conditions to determine a lightning threat. In one example, when an SSPC experiences multiple instantaneous trips within a predetermined time, it will turn off its SSPC output and set a circuit breaker protective trip by opening a switch 42. In this example, microprocessor module 60 monitors each SSPC for a circuit breaker protective trip. If a sufficient number of circuit breaker protective trips have been activated within a preset defined period, the microprocessor module 60 may reset the tripped SSPCs so that current may pass to a load or plurality of loads, leaving the SSPCs undamaged and reducing the impact to the vehicle from multiple instances of tripped SSPCs from a common cause event such as lightning.

In either of the disclosed embodiments, there is a finite amount of time needed for the microprocessor module 60 to collect data, process that data, and command ON SSPCs to lockout instantaneous trip protection. Depending on timing and the lightning detection method selected, it may also be necessary to reset SSPC circuit breaker protective trips.

Although preferred embodiments of this invention have been disclosed, a worker of ordinary skill in this art would recognize that certain modifications would come within the scope of this invention. For that reason, the following claims should be studied to determine the true scope and content of this invention.

## Claims

1. A solid state power controller (18) comprising:
a solid state power switch (42) having a closed state and an open state;
means for sensing a current through the switch (42);
a module that controls the switch (42) with respect to an instantaneous current trip threshold;
a microcontroller (38) arranged to control the switch (42) to switch between the open and closed states; and
an overvoltage clamp arranged to place the switch (42) into a linear conducting condition when an overvoltage is applied thereto whilst the switch (42) is controlled to be open;
wherein the module controls the switch (42) to switch into the closed state when the sensing means senses that the current through the switch (42) exceeds the instantaneous current trip threshold whilst the switch (42) is controlled by the microcontroller (38) to be in the open state; and
wherein the switch (42) is controlled to switch into the open state when the current through the switch (42) exceeds the instantaneous current trip threshold whilst the switch (42) is controlled to be in the closed state, and wherein if subsequent to the switch (42) being controlled to switch into the open state the current through the switch (42) exceeds a lightning threshold which is higher than the instantaneous current trip threshold, it is controlled to switch into the closed state.

2. A solid state power controller (18) as claimed in claim 1 wherein the switch (42) is arranged to be opened when the current subsequently falls below the instantaneous current trip threshold whilst the switch is controlled by the microcontroller to be in the open state.

3. A solid state power controller (18) as claimed in claim 2 wherein the switch (42) is opened after a delay after the current falls below the instantaneous current trip threshold.

4. A solid state power controller (18) as claimed in any of claims 1 to 3 wherein the module is able to directly close the switch (42) without requiring a closing control signal from the microcontroller (38).

5. A solid state power controller (18) as claimed in any preceding claim wherein the switch (42) is controlled to switch into the open state by the microcontroller (38).

6. A solid state power controller (18) as claimed in any preceding claim wherein when the switch (42) has been in the open state for a predetermined time, it is controlled to switch into the closed state.

7. A solid state power controller (18) as claimed in claim 6 wherein the cycle of opening the switch (42) and closing it after a predetermined time can repeat, and after a predetermined number of cycles a protective trip is set in which the switch (42) is held open.

8. A solid state power controller (18) as claimed in any preceding claim further including a gate drive (40) that interfaces between each of the microcontroller (38) and module and the switch (42) to selectively change the switch (42) between the closed state and the open state.

9. A power supply system comprising a solid state power controller (18) as claimed in any preceding claim further comprising at least one further solid state power controller;
at least one power distribution unit (64), wherein the or each power distribution unit (64) is associated with a plurality of solid state power controllers (18);
at least one solid state power controller communications interface (66), wherein the or each solid state power controller communications interface (66) corresponds to a power distribution unit (64);
a microprocessor module (60); and
a serial communications interface (62), wherein the serial communications interface (62) corresponds to the microprocessor module (60) and communicates with the solid state power controller communications interface (66).

10. A power supply system comprising:
a plurality of solid state power controllers (18) as claimed in claim 1;
at least one power distribution unit (64), wherein the or each power distribution unit (64) is associated with a plurality of solid state power controllers (18);
at least one solid state power controller communications interface (66), wherein the or each solid state power controller communications interface corresponds to a power distribution unit (64);
a microprocessor module (60); and
a serial communications interface (62), wherein the serial communications interface (62) corresponds to the microprocessor module (60) and communicates with the solid state power controller communications interface (66).

11. A power supply system as claimed in claim 9 or 10, wherein each power distribution unit (64) communicates power surge data to the microprocessor module (60) and receives commands from the microprocessor module (60) via the solid state power controller communications interface (66) associated with the power distribution unit (64).

12. A power supply system as claimed in claim 9, 10 or 11, wherein the solid state power controllers (18) comprise said switch (42) and an instantaneous trip module (44), and wherein the instantaneous trip module (44) is operable to either open or close the main switch (42) in response to a current meeting or exceeding the instantaneous current trip threshold.

13. A power supply system as claimed in claim 1 or 12, wherein the microprocessor module (60) analyzes power surge data, and is operable to disable instantaneous trip protection in a solid state power controller (18) for a predetermined time.

14. A power supply system as claimed in claim 13, wherein the predetermined time is substantially 1.5 seconds.

15. A power supply system as claimed in any of claims 9 to 14, wherein the individual solid state power controllers (18) are able to independently set a circuit breaker protective trip if a plurality of instantaneous trips occur in the solid state power controller (18) within a predetermined time period.

16. A power supply system as claimed in any of claims 9 to 15, wherein the microprocessor module (60) collects information from a group of solid state power controllers when the current in any single solid state power controller (18) exceeds the instantaneous current trip threshold, and determines if the quantity of solid state power controllers (18) within the group in which the current exceeds the instantaneous current trip threshold is sufficient to indicate a lightning threat to the group.

17. A power supply system as claimed in claim 16, wherein the microprocessor module (60) disables the responses of the modules to the instantaneous current trip threshold for the group of solid state power controllers (18) for a predetermined period if the quantity of solid state power controllers (18) within the group in which the current exceeds the instantaneous current trip threshold is sufficient to indicate a lightning threat to the group.

18. A power supply system as claimed in claim 16 or 17, wherein a sufficient quantity of solid state power controllers (18) is three or more solid state power controllers (18).

19. A power supply system as claimed in claim 17 or 18, wherein the response to the instantaneous current trip threshold is disabled when the respective switch (42) is controlled to be in a closed state.

20. A power supply system as claimed in claim 17, 18 or 19, wherein the predetermined period is substantially 1.5 seconds.

## Patentansprüche

1. Halbleiter-Leistungssteuerung (18), aufweisend:
einen Halbleiter-Leistungsschalter (42) mit einem geschlossenen Zustand und einem geöffneten Zustand;
eine Einrichtung zum Abtasten eines durch den Schalter (42) fließenden Stromes;
ein Modul, das den Schalter im Hinblick auf einen momentanen Auslösestrom-Schwellenwert steuert;
einen zum Steuern des Schalters (42) eingerichteten Mikrocontroller (38) zum Umschalten zwischen dem geöffneten und dem geschlossenen Zustand; und
ein zum Versetzen des Schalters (42) in einen linearen Leitzustand eingerichteten Überspannungsbegrenzer, wenn eine Überspannung darauf angewendet wird, während der Schalter (42) angesteuert wird, geöffnet zu sein;
wobei das Modul den Schalter (42) in den geschlossenen Zustand steuert, wenn die Abtasteinrichtung abtastet, dass der durch den Schalter (42) fließende Strom den momentanen Auslösestrom-Schwellenwert überschreitet, während der Schalter (42) durch den Mikrocontroller (38) gesteuert wird, in dem geöffneten Zustand zu sein; und
wobei der Schalter (42) gesteuert wird, in den geöffneten Zustand zu schalten, wenn der durch den Schalter (42) fließende Strom den momentanen Auslösestrom-Schwellenwert überschreitet, während der Schalter (42) gesteuert wird, in dem geschlossenen Zustand zu sein; und
wobei er gesteuert wird, in den geschlossenen Zustand zu schalten, wenn, nachdem der Schalter (42) gesteuert wird, in den geöffneten Zustand zu schalten, der durch den Schalter (42) fließende Strom einen Blitzschlagsschwellenwert überschreitet, der größer als der momentane Auslösestrom-Schwellenwert ist.

2. Halbleiter-Leistungssteuerung (18) nach Anspruch 1, wobei der Schalter (42) eingerichtet ist, geöffnet zu werden, wenn der Strom nachfolgend unter den Wert des momentanen Auslösestrom-Schwellenwertes fällt, während der Schalter durch den Mikrocontroller gesteuert wird, in dem geöffneten Zustand zu sein.

3. Halbleiter-Leistungssteuerung (18) nach Anspruch 2, wobei der Schalter (42) nach einer Verzögerung, nachdem der Strom unter den Wert momentanen Auslösestrom-Schwellenwert fällt, geöffnet wird.

4. Halbleiter-Leistungssteuerung (18) nach einem der Ansprüche 1 bis 3, wobei das Modul in der Lage ist, den Schalter (42) direkt zu schließen, ohne dass ein schließendes Steuersignal von dem Mikrocontroller (38) erforderlich ist.

5. Halbleiter-Leistungssteuerung (18) nach einem vorstehenden Anspruch, wobei der Schalter (42) durch den Mikrocontroller (38) gesteuert wird, in den offenen Zustand zu schalten.

6. Halbleiter-Leistungssteuerung (18) nach einem vorstehenden Anspruch, wobei der Schalter (42) gesteuert wird, in den geschlossenen Zustand zu schalten, wenn er für eine vorbestimmte Zeit in dem geöffneten Zustand gewesen ist.

7. Halbleiter-Leistungssteuerung (18) nach Anspruch 6, wobei der Zyklus des Öffnens des Schalters (42) und des Schließen desselben nach einer vorbestimmten Zeit sich wiederholen kann, und nach einer vorbestimmten Anzahl von Zyklen eine Schutzauslösung eingestellt wird, in welcher der Schalter (42) geöffnet gehalten wird.

8. Halbleiter-Leistungssteuerung (18) nach einem vorstehenden Anspruch, ferner aufweisend eine Gate-Ansteuerung (40), die ein Interface zwischen dem Mikrocontroller (38) und dem Modul einerseits und dem Schalter (42) andererseits bildet zum selektiven Umschalten des Schalters (42) zwischen dem geschlossenen Zustand und dem geöffneten Zustand.

9. Stromversorgungssystem, aufweisend eine Halbleiter-Leistungssteuerung (18) nach einem vorstehenden Anspruch, ferner aufweisend mindestens eine weitere Halbleiter-Leistungssteuerung;
mindestens eine Leistungs-Verteilungseinheit (64), wobei die oder jede Leistungsverteilungseinheit (64) mit einer Mehrzahl von Halbleiter-Leistungssteuerungen (18) verknüpft ist;
mindestens ein Halbleiter-Leistungssteuerungs-Kommunikationsinterface (66), wobei das oder die Halbleiter-Leistungssteuerungs-Kommunikationsinterfaces (66) einer Leistungsverteilungseinheit (64) entsprechen;
ein Mikroprozessor-Modul (60); und
ein serielles Kommunikationsinterface (62), wobei das serielle Kommunikationsinterface (62) dem Mikroprozessormodul (60) entspricht und mit dem Halbleiter-Leistungssteuerungs-Kommunikationsinterface (66) kommuniziert.

10. Stromversorgungssystem, aufweisend:
eine Mehrzahl von Halbleiter-Leistungssteuerungen (18) nach Anspruch 1;
mindestens eine Leistungsverteilungseinheit (64), wobei die oder jede Leistungsverteilungseinheit (64) mit einer Mehrzahl von Halbleiter-Leistungssteuerungen (18) verknüpft ist;
mindestens ein Halbleiter-Leistungssteuerungs-Kommunikationsinterface (66), wobei das oder die Halbleiter-Leistungssteuerungs-Kommunikationsinterfaces einer Leistungsverteilungseinheit (64) entsprechen;
ein Mikroprozessor-Modul (60), und
ein serielles Kommunikationsinterface (62), wobei das serielle Kommunikationsinterface (62) dem Mikroprozessor-Modul (60) entspricht und mit dem Halbleiter-Leistungssteuerungs-Kommunikationsinterface (66) kommuniziert.

11. Stromversorgungssystem nach Anspruch 9 oder 10, wobei jede Leistungsverteilungseinheit (64) Leistungsspitzendaten an das Mikroprozessor-Modul (60) kommuniziert und Befehle von dem Mikroprozessor-Modul (60) über das Halbleiter-Leistungssteuerungs-Kommunikationsinterface (66) entgegennimmt, die mit der Leistungsverteilungseinheit (64) verknüpft sind.

12. Stromversorgungssystem nach Anspruch 9, 10 oder 11, wobei die Halbleiter-Leistungssteuerung (18) den Schalter (42) und das verzögerungsfreie Auslösungsmodul (44) umfassen, und wobei das verzögerungsfreie Auslösungsmodul (44) betreibbar ist, um entweder den Hauptschalter (42) in Abhängigkeit von einem Strom zu öffnen oder zu schließen, welcher den momentanen Auslösestrom-Schwellenwert erreicht oder überschreitet.

13. Stromversorgungssystem nach Anspruch 11 oder 12, wobei das Mikroprozessor-Modul (60) Leistungsspitzendaten analysiert und betreibbar ist, um die verzögerungsfreie Schutzauslösung in einer Halbleiter-Leistungssteuerung (18) für eine vorbestimmte Zeit zu sperren.

14. Stromversorgungssystem nach Anspruch 13, wobei die vorbestimmte Zeit im wesentlichen 1,5 Sekunden beträgt.

15. Stromversorgungssystem nach einem der Ansprüche 9 bis 14, wobei die individuellen Halbleiter-Leistungssteuerungen (18) in der Lage sind, unabhängig eine Ausschalter-Schutzauslösung einzustellen, wenn eine Mehrzahl von augenblicklichen Auslösungen in der Halbleiter-Leistungssteuerung (18) innerhalb einer vorbestimmten Zeitdauer auftreten.

16. Stromversorgungssystem nach einem der Ansprüche 9 bis 15, wobei das Mikroprozessor-Modul (60) Informationen von einer Gruppe von Halbleiter-Leistungssteuerungen sammelt, wenn der Strom in irgendeiner einzelnen Halbleiter-Leistungssteuerung (18) den momentanen Auslösestrom-Schwellenwert überschreitet, und feststellt, ob die Quantität an Halbleiter-Leistungssteuerungen (18) innerhalb der Gruppe, in welcher der Strom den momentanen Auslösestrom-Schwellenwert überschreitet, ausreicht, um der Gruppe eine Blitzeinschlagsgefahr anzuzeigen.

17. Stromversorgungssystem nach Anspruch 16, wobei das Mikroprozessor-Modul (60) die Antworten der Module auf den momentanen Auslösestrom-Schwellenwert für die Gruppe von Halbleiter-Leistungssteuerungen (18) für eine vorbestimmte Periode sperrt, wenn die Quantität der Halbleiter-Leistungssteuerungen (18) innerhalb der Gruppe, in welcher der Strom den momentanen Auslösestrom-Schwellenwert übersteigt, ausreicht, um der Gruppe eine Blitzeinschlagsgefahr anzuzeigen.

18. Stromversorgungssystem nach Anspruch 16 oder 17, wobei eine ausreichende Quantität an Halbleiter-Leistungssteuerungen (18) drei oder mehr Halbleiter-Leistungssteuerungen (18) beinhaltet.

19. Stromversorgungssystem nach Anspruch 17 oder 18, wobei die Antwort auf den momentanen Auslösestrom-Schwellenwert gesperrt wird, wenn der entsprechende Schalter (42) gesteuert wird, in einem geschlossenen Zustand zu sein.

20. Stromversorgungssystem nach Anspruch 17, 18 oder 19, wobei die vorbestimmte Periode im wesentlichen 1,5 Sekunden beträgt.

## Revendications

1. Unité de commande à semi-conducteurs (18) comprenant :
un commutateur à semi-conducteur (42) ayant un état fermé et un état ouvert ;
un moyen pour détecter un courant à travers le commutateur (42) ;
un module qui commande le commutateur (42) par rapport à un seuil de coupure de courant instantanée ;
un microcontrôleur (38) agencé pour commander le commutateur (42) pour effectuer une commutation entre les états ouvert et fermé ; et
une pince de surtension agencée pour placer le commutateur (42) dans une condition de conduction linéaire lorsqu'une surtension lui est appliquée tandis que le commutateur (42) est commandé pour être ouvert ;
où le module commande le commutateur (42) pour effectuer une commutation à l'état fermé lorsque le moyen de détection détecte que le courant à travers le commutateur (42) excède le seuil de coupure de courant instantanée tandis que le commutateur (42) est commandé par le microcontrôleur (38) pour être dans l'état ouvert ; et
où le commutateur (42) est commandé pour effectuer une commutation à l'état ouvert lorsque le courant à travers le commutateur (42) excède le seuil de coupure de courant instantanée tandis que le commutateur (42) est commandé pour être dans l'état fermé, et où si après la commande du commutateur (42) pour effectuer une commutation à l'état ouvert, le courant à travers le commutateur (42) excède un seuil de foudre qui est plus élevé que le seuil de coupure de courant instantanée, il est commandé pour effectuer une commutation à l'état fermé.

2. Unité de commande à semi-conducteurs (18) selon la revendication 1, dans laquelle le commutateur (42) est agencé pour être ouvert lorsque le courant chute ultérieurement sous le seuil de coupure de courant instantanée tandis que le commutateur est commandé par le microcontrôleur pour être à l'état ouvert.

3. Unité de commande à semi-conducteurs (18) selon la revendication 2, dans laquelle le commutateur (42) est ouvert après un retard après la chute du courant sous le seuil de coupure de courant instantanée.

4. Unité de commande à semi-conducteurs (18) selon l'une quelconque des revendications 1 à 3, dans laquelle le module est capable de fermer directement le commutateur (42) sans demander un signal de commande de fermeture auprès du microcontrôleur (38).

5. Unité de commande à semi-conducteurs (18) selon l'une quelconque des revendications précédentes, dans laquelle le commutateur (42) est commandé pour effectuer une commutation à l'état ouvert par le microcontrôleur (38).

6. Unité de commande à semi-conducteurs (18) selon l'une quelconque des revendications précédentes, dans laquelle lorsque le commutateur (42) a été dans l'état ouvert pendant une durée prédéterminée, il est commandé pour effectuer une commutation à l'état fermé.

7. Unité de commande à semi-conducteurs (18) selon la revendication 6, dans laquelle le cycle d'ouverture du commutateur (42) et de fermeture de celui-ci après une durée prédéterminée peut être répété, et après un nombre de cycles prédéterminé, une coupure de protection est établie dans laquelle le commutateur (42) est maintenu ouvert.

8. Unité de commande à semi-conducteurs (18) selon l'une quelconque des revendications précédentes, incluant en outre un pilote de grille (40) qui assure l'interface entre chacun du microcontrôleur (38) et du module et du commutateur (42) pour changer sélectivement le commutateur (42) entre l'état fermé et l'état ouvert.

9. Système d'alimentation comprenant une unité de commande à semi-conducteurs (18) selon l'une quelconque des revendications précédentes, comprenant en outre au moins une unité de commande à semi-conducteurs supplémentaire ;
au moins une unité de distribution d'énergie (64), dans laquelle l'unité de distribution (64) ou chaque unité de distribution (64) est associée à une pluralité d'unités de commande à semi-conducteurs (18) ;
au moins une interface de communications d'unité de commande à semi-conducteurs (66), dans laquelle l'interface ou chaque interface de communications d'unité de commande à semi-conducteurs (66) correspond à une unité de distribution d'énergie (64) ;
un module de microprocesseur (60) ; et
une interface de communications série (62), dans laquelle l'interface de communication série (62) correspond au module de microprocesseur (60) et communique avec l'interface de communications d'unité de commande à semi-conducteurs (66).

10. Système d'alimentation comprenant :
une pluralité d'unités de commande à semi-conducteurs (18) selon la revendication 1 ;
au moins une unité de distribution d'énergie (64), dans laquelle l'unité de distribution (64) ou chaque unité de distribution (64) est associée à une pluralité d'unités de commande à semi-conducteurs (18) ;
au moins une interface de communications d'unité de commande à semi-conducteurs (66), dans laquelle l'interface ou chaque interface de communications d'unité de commande à semi-conducteurs correspond à une unité de distribution d'énergie (64) ;
un module de microprocesseur (60) ; et
une interface de communications série (62), dans laquelle l'interface de communication série (62) correspond au module de microprocesseur (60) et communique avec l'interface de communications d'unité de commande à semi-conducteurs (66).

11. Système d'alimentation selon la revendication 9 ou 10, dans lequel chaque unité de distribution d'énergie (64) communique des données de surtension au module de microprocesseur (60) et reçoit des ordres du module de microprocesseur (60) via l'interface de communications d'unité de commande à semi-conducteurs (66) associée à l'unité de distribution d'énergie (64).

12. Système d'alimentation selon la revendication 9, 10 ou 11, dans lequel les unités de commande à semi-conducteurs (18) comprennent ledit commutateur (42) et un module de coupure instantanée (44), et où le module de coupure instantanée (44) est fonctionnel pour ouvrir ou fermer le commutateur principal (42) en réponse au fait qu'un courant est égal ou supérieur au seuil de coupure de courant instantanée.

13. Système d'alimentation selon la revendication 11 ou 12, dans lequel le module de microprocesseur (60) analyse des données de surtension, et est fonctionnel pour désactiver la protection par coupure instantanée dans une unité de commande à semi-conducteurs (18) pendant une durée prédéterminée.

14. Système d'alimentation selon la revendication 13, dans lequel la durée prédéterminée est sensiblement de 1,5 seconde.

15. Système d'alimentation selon l'une quelconque des revendications 9 à 14, dans lequel les unités de commande à semi-conducteurs (18) individuelles sont capables d'établir indépendamment une coupure de protection par disjoncteur si une pluralité de coupures instantanées survient dans l'unité de commande à semi-conducteurs (18) au cours d'une période prédéterminée.

16. Système d'alimentation selon l'une quelconque des revendications 9 à 15, dans lequel le module de microprocesseur (60) collecte des informations d'un groupe d'unités de commande à semi-conducteurs lorsque le courant dans une unité de commande à semi-conducteurs (18) individuelle excède le seuil de coupure de courant instantanée, et détermine si la quantité des unités de commande à semi-conducteurs (18) dans le groupe dans lequel le courant excède le seuil de coupure de courant instantanée est suffisante pour indiquer une menace de foudre au groupe.

17. Système d'alimentation selon la revendication 16, dans lequel le module de microprocesseur (60) désactive les réponses des modules au seuil de coupure de courant instantanée pour le groupe d'unités de commande à semi-conducteurs (18) pendant une période prédéterminée si la quantité d'unité de commande à semi-conducteurs (18) dans le groupe dans lequel le courant excède le seuil de coupure de courant instantanée est suffisante pour indiquer une menace de foudre au groupe.

18. Système d'alimentation selon la revendication 16 ou 17, dans lequel une quantité suffisante d'unité de commande à semi-conducteurs (18) est de trois unités de commande à semi-conducteurs (18) ou plus.

19. Système d'alimentation selon la revendication 17 ou 18, dans lequel la réponse au seuil de coupure de courant instantanée est désactivée lorsque le commutateur (42) respectif est commandé pour être dans un état fermé.

20. Système d'alimentation selon la revendication 17, 18 ou 19, dans lequel la période prédéterminée est sensiblement de 1,5 seconde.
